# FASCICULE DE BREVET EUROPEEN

(11) **EP 3 176 918 B1**
(45) Date de publication et mention de la délivrance du brevet: **23.10.2019**
(21) Numéro de dépôt: 16201069.8
(22) Date de dépôt: 29.11.2016
(51) Int. Cl.: H02K 5/08, H02K 11/04

(54) **ARCHITECTURE ELECTRONIQUE DESTINEE A ALIMENTER UNE MACHINE ELECTRIQUE POUR VEHICULE AUTOMOBILE**
ELEKTRONISCHER AUFBAU ZUR STROMVERSORGUNG EINER ELEKTRISCHEN MASCHINE FÜR EIN KRAFTFAHRZEUG
ELECTRONIC ARCHITECTURE INTENDED FOR POWERING AN ELECTRIC MACHINE FOR A MOTOR VEHICLE

(30) Priorité: 02.12.2015 FR 1561732
(43) Date de publication de la demande: 07.06.2017
(73) Titulaire: Valeo Systemes de Controle Moteur, 95800 Cergy Saint Christophe (FR)
(72) Inventeur: TRAMET, Guillaume, 78360 Montesson (FR); MAS, Arnaud, 95000 Cergy (FR); SACCO, Ernesto, 95000 Cergy (FR)
(74) Mandataire: Novembre, Christophe Adelphe

(56) Documents cités:
- FR-A1- 2 952 248
- FR-A1- 3 010 590
- US-A1- 2013 187 497

## Description

L'invention a pour objet une architecture électronique destinée à alimenter une machine électrique pour véhicule automobile. L'invention concerne également une machine électrique destinée à être intégrée dans un véhicule automobile et comprenant une telle architecture électronique.

Usuellement, une architecture électronique destinée à alimenter une machine électrique, notamment pour véhicule automobile, peut comprendre une pluralité d'unités électroniques, également appelés modules électroniques, les unités électroniques étant, par exemple, des unités électroniques de puissance, d'excitation ou de contrôle. Les documents US 2013/187497 A1 et FR 2 952 248 A1 présentent une telle architecture électronique. Chaque unité électronique comprend un boitier dans lequel l'électronique est intégrée, les boitiers des unités électroniques étant directement intégrés au sein de l'architecture électronique. Cependant, dans une telle architecture électronique, l'électronique de puissance et l'électronique de contrôle sont adjacentes au niveau du support des unités électroniques, ce qui peut induire des perturbations au niveau du fonctionnement de l'architecture électronique. En effet, la chaleur générée par les unités électroniques de puissance peut perturber le fonctionnement de l'unité électronique de contrôle. De plus, le boitier de chaque unité électronique peut altérer la dissipation de la chaleur générée par chaque unité électronique. En outre, comme chaque unité électronique comprend un boitier, une telle architecture électronique nécessite une place importante au sein de l'architecture électronique dans laquelle elle est destinée à être intégrée.

La présente invention vise à remédier à cet inconvénient en proposant une architecture électronique permettant une dissipation efficace de la chaleur générée au sein de l'architecture électronique, tout en minimisant l'encombrement de celle-ci.

A cet effet, l'invention a pour objet une architecture électronique destinée à alimenter une machine électrique pour véhicule automobile, l'architecture électronique comprenant au moins :
- une unité électronique de puissance ;
- un dissipateur thermique supportant l'unité électronique de puissance;
- une unité électronique de contrôle configurée pour contrôler ladite unité électronique de puissance ;
- un support de l'unité électronique de contrôle supportant l'unité électronique de contrôle et agencé entre l'unité électronique de puissance et l'unité électronique de contrôle ; et
- un connecteur électrique comprenant au moins une trace de puissance destinée à être connectée électriquement à au moins des éléments électriques de la machine électrique et/ou d'une source d'énergie électrique, le connecteur électrique étant agencé entre l'unité électronique de puissance et le support de l'unité électronique de contrôle et configuré pour connecter électriquement l'unité électronique de puissance et/ou l'unité électronique de contrôle à la au moins une trace de puissance.

Avantageusement, le découplage des unités électroniques de contrôle et de puissance au sein de l'architecture électronique permet une dissipation efficace de la chaleur générée par les unités électroniques.

En outre, une telle architecture électronique permet une réduction des coûts de production, notamment grâce à une réduction des coûts de fabrication de l'unité électronique de contrôle qui est isolée de l'unité électronique de puissance, et par conséquent éloignée de la chaleur générée par ladite unité électronique de puissance. En effet, une telle architecture électronique permet l'utilisation de composants pour l'unité électronique de contrôle nécessitant une plus faible tolérance à la chaleur, et par conséquent moins coûteux.

L'architecture électronique selon l'invention peut également comprendre une ou plusieurs des caractéristiques suivantes, considérées individuellement ou selon toutes les combinaisons possibles :
- l'unité électronique de puissance, le dissipateur thermique, le connecteur électrique, l'unité électronique de contrôle et le support de l'unité électronique de contrôle s'étendent chacun suivant des plans sensiblement parallèles, l'unité électronique de puissance, le dissipateur thermique et le connecteur électrique étant notamment superposés les uns sur les autres ;
- le connecteur électrique comprend :
   - une première trace de puissance destinée à connecter électriquement l'unité électronique de puissance à une phase de la machine électrique ;
   - une deuxième trace de puissance destinée à être connectée électriquement à un pôle de polarité positif d'une source d'énergie électrique de manière à alimenter l'unité électronique de puissance et/ou l'unité électronique de contrôle ; et
   - une troisième trace de puissance destinée à être connectée électriquement à un pôle de polarité négatif ou à la masse d'une source d'énergie électrique de manière à alimenter l'unité électronique de puissance et/ou l'unité électronique de contrôle ;
- l'architecture électronique comprend en outre au moins un élément de connexion électrique connectant électriquement l'unité électronique de puissance et l'unité électronique de contrôle ; et dans laquelle au moins un espace s'étend entre l'unité électronique de puissance et le support de l'unité électronique de contrôle et autour du au moins un élément de connexion électrique, ledit connecteur électrique s'étendant au moins en partie dans ledit espace autour de l'élément de connexion électrique ;
- l'architecture électronique comprend également un connecteur de bloc de capacités supporté par une deuxième partie du dissipateur thermique distincte d'une première partie supportant l'unité électronique de puissance ;
- la première partie du dissipateur thermique est destinée à être remplie d'un matériau isolant, de sorte que l'unité électronique de puissance est noyée dans le matériau isolant ;
- l'unité électronique de puissance, l'unité électronique de contrôle et le au moins un élément de connexion électrique sont noyés dans un matériau isolant, de sorte que le au moins un espace s'étendant autour du au moins un élément de connexion électrique entre l'unité électronique de puissance et le support de l'unité électronique de contrôle est dépourvu de matériau isolant ;
- l'architecture électronique comprend également un couvercle de protection agencé en vis-à-vis de l'unité électronique de contrôle ;
- l'unité électronique de puissance comprend au moins un module électronique de puissance, et l'unité électronique de contrôle est une carte électronique de contrôle.

Avantageusement, une telle architecture électronique permet une dissipation efficace de la chaleur générée par les unités électroniques, notamment grâce à l'espace dépourvu de matériau isolant entre lesdites unités électroniques.

En outre, une telle architecture permet une réduction des coûts de production, notamment grâce à une réduction de la quantité de matériau isolant nécessaire pour isoler les unités électroniques et les éléments de connexion électriques desdites unités électroniques.

L'invention a également pour objet une machine électrique destinée à être intégrée dans un véhicule automobile comprenant une architecture électronique selon l'invention. Par exemple, la machine électrique est un démarreur, un alterno-démarreur ou une autre machine électrique embarquée dans le véhicule.

D'autres caractéristiques et avantages de la présente invention apparaitront à la lecture de la description et des figures suivantes :
- la figure 1 est une vue éclatée d'un mode de réalisation d'une architecture électronique selon l'invention,
- la figure 2 est une vue éclatée d'une unité électronique de puissance et d'un dissipateur thermique selon un mode de réalisation de l'invention,
- la figure 3 est une vue éclatée d'une unité électronique de contrôle et d'un support de ladite unité électronique selon un mode réalisation de l'invention,
- la figure 4 représente un mode de réalisation d'un connecteur électrique et d'un connecteur de bloc de capacités selon l'invention,
- la figure 5 est une vue en coupe d'une architecture électronique de la figure 1 selon un mode de réalisation de l'invention, et
- la figure 6 est une vue éclatée d'une machine électrique selon un mode de réalisation de l'invention.

Il est à noter que ces dessins n'ont d'autre but que d'illustrer le texte de la description et ne constituent en aucune sorte une limitation de la portée de l'invention.

Sur les différentes figures, les éléments analogues sont désignés par des références identiques.

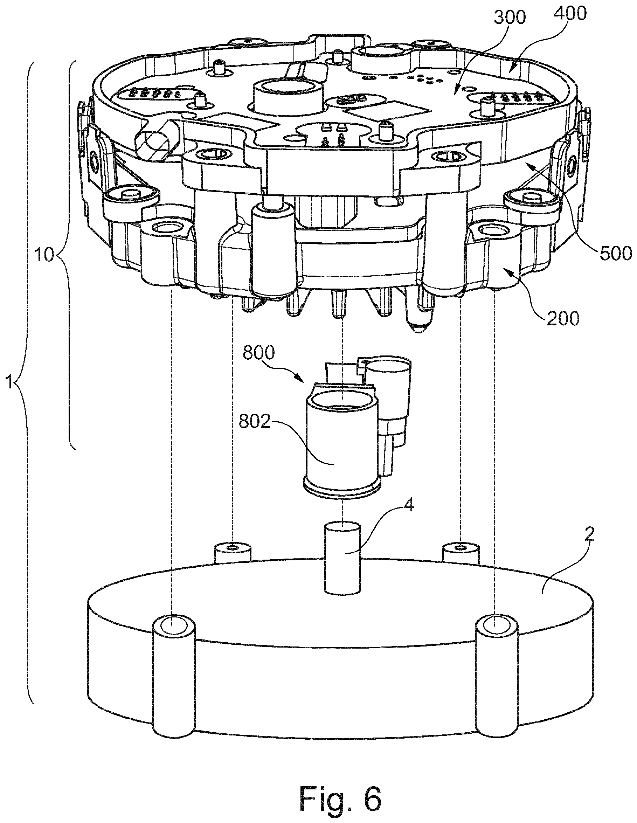

Une architecture électronique selon l'invention est destinée à alimenter une machine électrique pour véhicule automobile, telle qu'une machine électrique tournante. En particulier, la figure 6 représente une machine électrique 1 comprenant une architecture électronique 10 selon un mode de réalisation de l'invention. L'architecture électronique 10 est notamment destinée à être montée sur le carter 2 de la machine électrique 1. En particulier, l'architecture électronique 10 est destinée à être vissée au carter 2 de la machine électrique 1. Cependant, l'architecture électronique 10 pourrait ne pas être montée sur le carter 2 de la machine électrique 1. Par exemple, l'architecture électronique 10 pourrait être montée sur un support indépendant de la machine électrique 1. Par exemple, la machine électrique est un démarreur, un alterno-démarreur ou une autre machine embarquée dans le véhicule.

Une telle architecture électronique comprend au moins une unité électronique de puissance, notamment destinée à alimenter en puissance la machine électrique 1, et une unité électronique de contrôle, notamment destinée à contrôler l'unité électronique de puissance.

L'unité électronique de puissance peut, par exemple, être un ou plusieurs modules électroniques de puissance, tels qu'illustrés sur les figures. Bien entendu, l'unité électronique de puissance n'est nullement limitée aux modules électroniques de puissance, mais au contraire l'unité électronique de puissance pourrait être tout autre composant électronique de puissance destiné à alimenter en puissance une machine électrique.

De même, dans la suite de la description, l'unité électronique de contrôle est une carte électronique de contrôle comme illustrée sur les figures. Bien entendu, l'unité électronique de contrôle pourrait être tout autre composant électronique de contrôle.

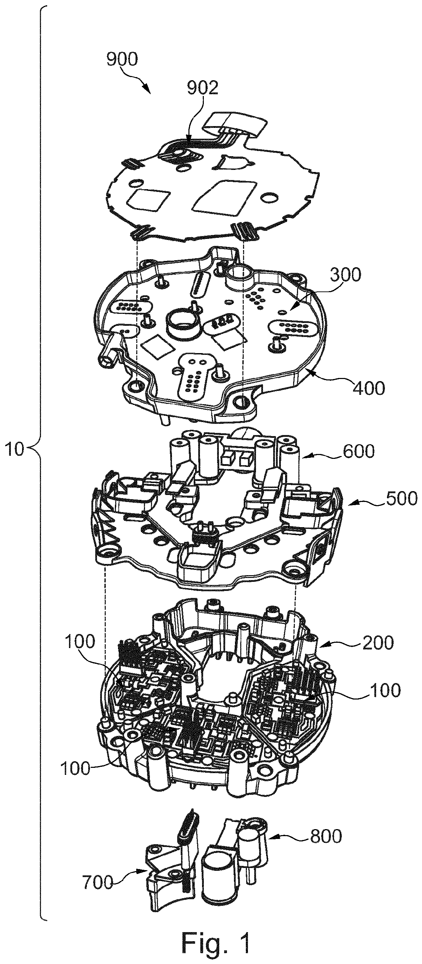

En particulier, une architecture électronique selon un mode de réalisation de l'invention est représentée en figure 1. L'architecture électronique 10 comprend au moins un module électronique de puissance 100, ici au nombre de trois, un dissipateur thermique 200, une carte électronique de contrôle 300, un support 400 de carte électronique et un connecteur électrique 500.

Le dissipateur thermique 200 supporte les modules électroniques de puissance 100, et le support 400 de carte électronique supporte la carte électronique de contrôle 300. Le support 400 de carte électronique est agencé entre les modules électroniques de puissance 100 et la carte électronique de contrôle 300. Le connecteur électrique 500 est agencé entre les modules électroniques de puissance 100 et le support de la carte électronique de contrôle 400.

De préférence, les modules électroniques de puissance 100, le dissipateur thermique 200, le connecteur électrique 500, la carte électronique de contrôle 300 et le support 400 de la carte électronique s'étendent chacun suivant des plans sensiblement parallèles. En particulier, les modules électroniques de puissance 100, le dissipateur thermique 200 et le connecteur électrique 500 sont notamment superposés les uns sur les autres, comme représenté sur la figure 1.

En outre, selon le mode de réalisation illustré, l'architecture électronique 10 comprend avantageusement un connecteur de bloc de capacités 600, un porte-capteur 700, un porte-balai 800 et un couvercle de protection 900. Le connecteur de bloc de capacités 600 est de préférence agencé entre la carte électronique de contrôle 300 et les modules électroniques de puissance 100, de sorte que le connecteur 600 et les unités électroniques sont superposés. Le couvercle de protection 900 est agencé en vis-à-vis de la carte électronique de contrôle 300.

Les différents éléments de l'architecture électronique sont détaillés dans la suite de la description.

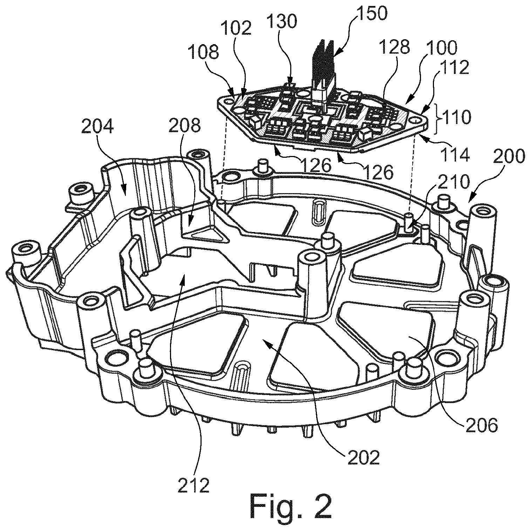

En particulier, la figure 2 représente un ensemble comprenant une unité électronique de puissance, ici un module électronique de puissance 100, et un dissipateur thermique 200.

Le module électronique de puissance 100 comprend un substrat plan 110, comprenant une face supérieure 112 et une face inférieure 114, la face inférieure 114 étant agencée en regard du dissipateur thermique 200. Le substrat plan 110 comprend au moins une trace de puissance surmoulée au moins en partie de matériau isolant électriquement, de préférence de matériau plastique. En particulier, le substrat plan 110 du module électronique de puissance 100 comprend trois traces de puissance 102 surmoulées au moins en partie de matériau isolant électriquement. Une trace de puissance est une trace conductrice électriquement, notamment métallique, par exemple une lame métallique, telle qu'entre autres une lame de cuivre. Une trace de puissance est notamment configurée pour supporter un courant électrique destiné à circuler dans la machine électrique.

Chaque trace de puissance 102 comprend au moins une portion dépourvue de surmoulage, notamment destinée à être connectée électriquement à des éléments électriques extérieurs au module électronique de puissance 100, par exemple à des éléments électriques de la machine électrique. Par exemple, la première trace de puissance est destinée à être connectée électriquement à une phase de la machine électrique, la deuxième trace de puissance est destinée à être connectée électriquement à un pôle de polarité positif d'une source d'énergie électrique, et la troisième trace de puissance est destinée à être connectée électriquement à un pôle de polarité négatif ou à un potentiel de référence, par exemple à la masse, d'une source d'énergie électrique.

L'épaisseur du substrat plan 110 est comprise par exemple entre 0,5 mm et 5 mm, et dépend, en général, de l'épaisseur des traces de puissance. Par exemple, l'épaisseur des traces de puissance est comprise entre 600 microns et 2000 microns.

De préférence, le substrat plan 110 est dépourvu de parois latérales s'étendant depuis le substrat plan 110 et notamment depuis la face supérieure 112 du substrat plan 110, permettant une simplification du procédé de fabrication, ainsi qu'un gain de place au sein de l'architecture électronique.

Selon un mode de réalisation préféré, le substrat plan 110 comprend une partie supérieure et une partie inférieure, avantageusement formées en continuité de matière. En particulier, la partie supérieure comprend au moins une trace de puissance 102, et la partie inférieure comprend au moins une cavité ouverte 126, notamment visible sur la figure 2. Le fond de la cavité ouverte 126 est de préférence formé au moins en partie par au moins une portion d'une trace de puissance. Le surmoulage 108 des traces de puissance 102 forme au moins en partie le bord des cavités ouvertes 126. En particulier, comme représenté sur la figure 2, le module électronique de puissance 100 comprend deux cavités ouvertes 126. Les cavités ouvertes permettent notamment une dissipation thermique.

Comme représenté sur la figure 2, le module électronique de puissance 100 comprend au moins un composant électronique 128, agencé sur la face supérieure 112 du substrat plan 110, de sorte à être connecté électriquement à une des traces de puissance.

Le module électronique de puissance 100 peut également comprendre au moins un élément de connexion extérieure 130 destiné à connecter électriquement une trace de puissance du module électronique de puissance 100 à au moins un élément électrique extérieur au module électronique de puissance 100, par exemple au connecteur électrique 500. L'élément de connexion extérieure 130 est disposé sur la même face du substrat plan 110 que le composant électronique 128. L'élément de connexion extérieure 130 peut comprendre une languette en matériau conducteur pliée, par exemple en forme de « Z », de sorte à comprendre au moins une face plane inférieure en contact avec le substrat plan 110, notamment avec la trace de puissance, et une face plane supérieure destinée à être connectée électriquement à l'élément électrique extérieur au module électronique de puissance 100, par exemple au connecteur électrique 500.

De préférence, le montage des éléments de connexion extérieure 130 et des composants électroniques 128 sur le substrat plan 110 est obtenu par dépôt de pâte à braser puis par disposition des composants électroniques 128 et des éléments de connexion extérieure 130 en surface du substrat plan 110 du module électronique de puissance (« CMS »). Le matériau isolant électriquement du substrat plan 110 du module électronique 100 est avantageusement du type matériau plastique haute température, de sorte à ne pas être altéré lors du passage du module électronique 100 au four pour la refusion des composants. Un tel procédé de fabrication des modules électroniques permet de diminuer le nombre de liaisons entre les composants du module électronique 100, notamment les composants électroniques 128 et les éléments de connexion extérieure 130, et ainsi de simplifier le procédé de fabrication et d'assemblage des modules électroniques.

De plus, le montage des composants électroniques 128 et des éléments de connexion extérieure 130 directement sur le substrat plan 110 permet un gain de place au sein de l'architecture électronique 10.

En particulier, les composants électroniques 128 et/ou les éléments de connexion extérieure 130 sont montés sur une trace de puissance 102. Notamment, un contact électrique est réalisé avec la trace de puissance 102 par la face du composant électronique 128 ou de l'élément de connexion 130 qui est en contact avec la trace de puissance 102. En outre, chaque composant électronique 128 peut être en contact électrique avec d'autres composants électroniques 128, ou une autre trace de puissance que celle sur laquelle elle est montée, notamment par des fils de connexions, également appelés « bonding » en anglais.

Le module électronique de puissance 100 tel que décrit précédemment est reçu par le dissipateur thermique 200. En effet, le dissipateur thermique 200 comprend une première partie 202 formant une cavité de réception d'un ou d'une pluralité de modules électroniques de puissance 100, et une deuxième partie 204 détaillée par la suite de la description.

Le dissipateur thermique 200 est configuré pour permettre une conduction thermique et électrique, notamment pour la reprise de la masse et la dissipation de la chaleur. La première partie 202 comprend un fond à partir duquel s'étend de façon sensiblement perpendiculaire au moins une protubérance 206 du dissipateur thermique 200. La ou chaque cavité ouverte 126 du module électronique de puissance 100 est destinée à recevoir au moins une protubérance 206.

La ou chaque protubérance 206 est destinée à être recouverte d'un matériau conducteur thermiquement et isolant électriquement, par exemple une graisse thermique. La ou chaque protubérance 206 est en contact avec le fond de chaque cavité 126 du module électronique de puissance 100. En particulier, le module électronique de puissance 100 est supporté mécaniquement par la au moins une protubérance 206. Autrement dit, le module électronique de puissance 100 est destiné à être en appui sur les protubérances 206 du dissipateur thermique 200, de sorte qu'un espace entre le module électronique de puissance 100 et le reste du fond de la première partie 202 du dissipateur thermique 200 en résulte. On s'assure ainsi d'un contact mécanique entre le module électronique de puissance 100 et la protubérance 206 pour permettre une dissipation thermique efficace du module électronique de puissance 100.

En outre, la première partie 202 du dissipateur thermique 200 peut comprendre des éléments de positionnement 210 destinés à positionner les modules électroniques 100 sur le dissipateur thermique 200 dans une position prédéterminée. Ces éléments de positionnement 210 permettent de faciliter et garantir un positionnement correct et rapide des modules électroniques 100 sur le dissipateur thermique 200.

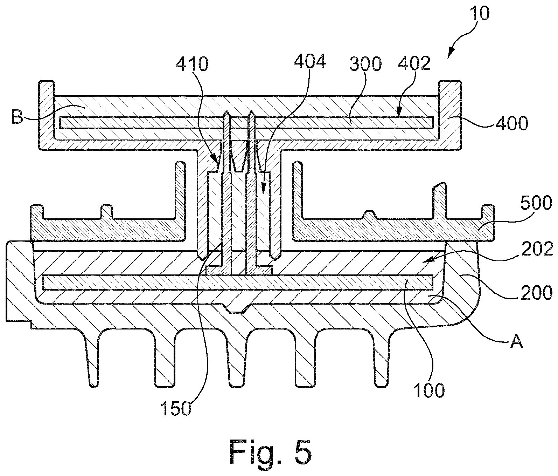

Avantageusement, la première partie 202 du dissipateur thermique 200 est destinée à être remplie d'un matériau isolant A, notamment visible sur la figure 5, de sorte que le module électronique de puissance 100 est noyé dans le matériau isolant A. Le matériau isolant peut être un gel isolant, par exemple un gel en silicone, ou une résine isolante, par exemple une résine époxy. Ainsi, cette configuration permet une isolation efficace des modules électroniques 100.

Les modules de puissance 100 sont fixés au dissipateur thermique 200, par exemple collés sur le fond de la première partie 202 du dissipateur thermique 200, pour permettre le transfert thermique entre les modules de puissance 100 et un circuit de refroidissement (non représenté), afin de dissiper la chaleur générée par les modules électroniques 100.

En outre, l'architecture électronique 10 comprend au moins un élément de connexion électrique 150 configuré pour connecter électriquement un module électronique de puissance 100 à la carte électronique de contrôle. Chaque élément de connexion électrique 150 est de préférence disposé sur le substrat plan 110 du module électronique de puissance 100 qui le supporte, tel que représenté sur la figure 2, et est destiné à être connecté électriquement à la carte électronique de contrôle.

De façon avantageuse, au moins un espace s'étend entre les modules électroniques de puissance 100 et le support de la carte électronique et autour du ou de chaque élément de connexion électrique 150. En particulier, le connecteur électrique 10 s'étend au moins en partie dans ledit espace. Autrement dit, le connecteur électrique 10 est situé entre les modules électroniques de puissance 100 et le support de la carte électronique, et autour des éléments de connexion électrique 150. Plus précisément, le connecteur électrique 10 comprend des orifices traversants, détaillés par la suite, configurés pour recevoir les éléments de connexion électriques, de sorte qu'une partie de l'espace résulte de part et d'autre du connecteur électrique. Cet espace est avantageusement configuré pour permettre une circulation d'air.

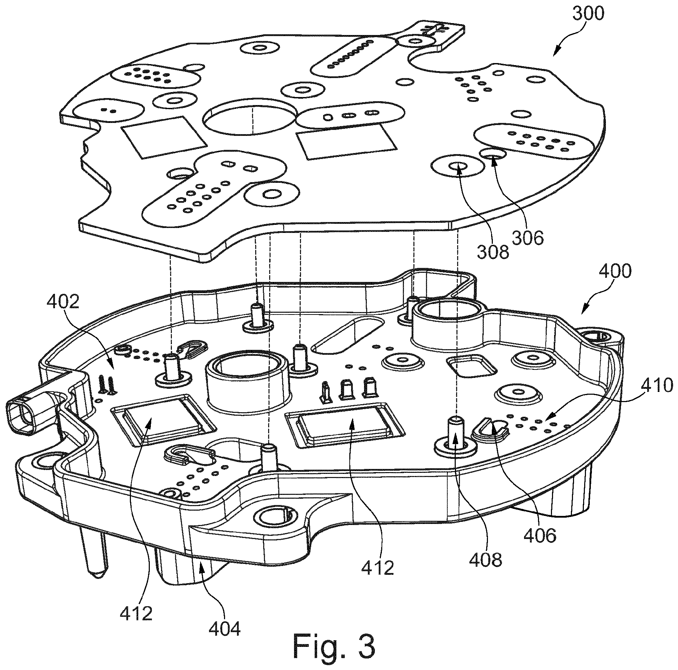

La figure 3 représente un ensemble comprenant l'unité électronique de contrôle, ici une carte électronique de contrôle 300, et le support 400 de ladite carte électronique. Notamment, la carte électronique de contrôle 300 est soudée au support 400.

Le support 400 de la carte électronique est de préférence en matière isolante, par exemple moulé en matière plastique. Le support 400 comprend une cavité ouverte 402 ayant un fond sur lequel la carte électronique 300 est reçue.

La cavité ouverte 402 est destinée à être remplie d'un matériau isolant de sorte que la carte électronique de contrôle 300 est noyée dans le matériau isolant. Par exemple, comme représenté sur la figure 5, la carte électronique est noyée dans un matériau isolant B. La carte électronique de contrôle 300 est ainsi isolée de manière efficace.

Le support 400 comprend également au moins une colonne creuse 404 dans laquelle le ou chaque élément de connexion électrique 150 de la carte électronique 300 avec les modules électroniques 100 est inséré. La colonne creuse 404 s'étend depuis la cavité ouverte 402 et est configurée pour communiquer avec la cavité ouverte 402 à une première extrémité de la colonne creuse 404. En particulier, le support 400 de la carte électronique peut comprendre une pluralité de colonnes creuses, chaque colonne creuse étant destinée à recevoir les éléments de connexion électrique 150 de chaque module électronique 100 avec la carte électronique de contrôle 300.

Avantageusement, le support 400 de la carte électronique peut comprendre un canal 406, également appelé élément de remplissage de la colonne creuse 404. Bien entendu, le support 400 peut comprendre une pluralité de canaux 406, chaque canal 406 étant associé à une colonne creuse 404. Par exemple, sur la figure 3, le support 400 de la carte électronique comprend trois canaux 406, chaque canal 406 permettant respectivement le remplissage d'une colonne creuse 404.

Préférentiellement, le canal 406 a une forme générale de rampe, par exemple une forme hélicoïdale. Une extrémité du canal 406 communique avec le fond de la cavité ouverte 402 et une autre extrémité du canal 406 communique avec une paroi latérale de la colonne creuse 404. Le canal 406 permet ainsi un accès rapide et peu encombrant à l'intérieur de la colonne creuse 404.

La colonne creuse 404 est remplie de matériau isolant B, notamment par l'intermédiaire du canal 406 lors du dépôt de matériau isolant sur la carte électronique de contrôle 300 ou dans la cavité ouverte 402, de sorte que les éléments de connexion électrique 150 sont noyés dans le matériau isolant B. Le canal 406 assure un remplissage correct de la colonne creuse 404 par le matériau isolant B, permettant ainsi de garantir une isolation électrique efficace des éléments de connexion électrique 150.

De façon avantageuse, comme illustré sur la figure 5, une seconde extrémité de la colonne creuse 404 est en contact avec le matériau isolant A dans lequel le module électronique 100 est noyé. Cette configuration permet de garantir le remplissage de la colonne creuse 404 de matériau isolant B, et ainsi d'assurer une isolation efficace à la poussière, aux liquides, aux gaz ou encore à l'humidité des éléments de connexion électrique 150. Le matériau isolant permet ainsi de supprimer tout risque de court-circuit possible au niveau de l'interconnexion de la carte électronique 300 avec les modules électroniques de puissance 100.

En particulier, la carte électronique de contrôle 300 et les modules électroniques de puissance 100 peuvent être isolés avec des matériaux isolants A, B identiques ou différents, de préférence un matériau isolant identique, notamment un gel isolant.

L'interface entre le matériau isolant A du module électronique de puissance 100 et le matériau isolant B de la carte électronique de contrôle 300 est notamment située à l'intérieur de la colonne creuse 404, à proximité de la seconde extrémité de la colonne creuse 404, comme représenté sur la figure 5.

L'espace compris entre la carte électronique 300 et le module de puissance 100 et s'étendant autour des éléments de connexion électrique 150, et plus précisément autour des colonnes creuses 404, est dépourvu de matière, notamment de matériau isolant. L'espace libre de matière, notamment de matériau isolant, a, entre autres, pour effet de laisser un espace libre pour la circulation d'air, permettant ainsi un refroidissement par convection. En particulier, cette configuration permet de diminuer les coûts de production de l'architecture électronique, grâce notamment à un gain en matériau isolant. Cet espace libre de matière reçoit au moins en partie le connecteur électrique 500.

En outre, la carte électronique de contrôle 300 peut comprendre avantageusement un orifice 306 agencé en vis-à-vis de l'extrémité du canal 406 communiquant avec le fond de la cavité ouverte 402 pour le remplissage de la colonne creuse 404 de matériau isolant B par l'intermédiaire du canal 406.

Le support 400 de la carte électronique comprend de préférence au moins un autre dissipateur thermique 412. Par exemple, sur la figure 3, le support 400 comprend deux dissipateurs thermiques, permettant une dissipation de la chaleur générée par la carte électronique 300.

En outre, le fond de la cavité ouverte 402 comprend de préférence des éléments de positionnement 408 destinés à positionner la carte électronique 300 sur le support 400 dans une position prédéterminée. Autrement dit, les éléments de positionnement 408 disposés sur le support 400 de la carte électronique sont destinés à coopérer avec des éléments de positionnement complémentaires 308 de la carte électronique 300. Par exemple, sur la figure 3, six éléments de positionnement 408 sont représentés, comprenant chacun un ergot de forme cylindrique faisant saillie depuis le fond de la cavité ouverte 402, de façon perpendiculaire au fond. Les six éléments de positionnement complémentaires 308 de la carte électronique 300 sont des orifices de positionnement présentant de préférence une section de forme et de dimensions complémentaires à la forme et aux dimensions des éléments de positionnement 408, ici une section circulaire. Ces éléments de positionnement 408 permettent de positionner correctement et rapidement la carte électronique 300 sur le support 400, et ainsi de permettre une connexion électrique efficace de la carte électronique 300 avec les modules électroniques de puissance 100.

De plus, le fond de la cavité ouverte 402 comprend avantageusement des éléments de guidage 410 du au moins un élément de connexion électrique 150 agencés à la première extrémité de la colonne creuse 404 et destinés à guider le au moins un élément de connexion électrique 150 vers la carte électronique 300. Par exemple, sur la figure 3, le fond de la cavité ouverte 402 comprend trois groupes d'éléments de guidage 410. Les éléments de guidage 410 comprennent des orifices de guidage permettant de recentrer les éléments de connexion électrique 150 en vue de la connexion électrique du module électronique 100 avec la carte électronique 300, et ainsi de connecter correctement le module électronique 100 avec la carte électronique 300. De préférence, comme illustré sur la figure 5, afin de permettre un meilleur recentrage des éléments de connexion électrique 150, la section des orifices de guidage en regard du module électronique 100 est plus grande que la section des orifices de guidage en regard de la carte électronique 300.

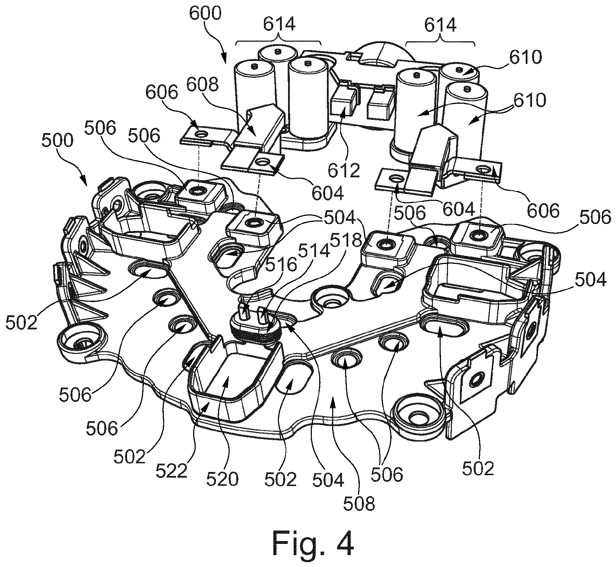

L'architecture électronique comprend également un connecteur électrique 500, notamment illustré en figure 4. Le connecteur électrique 500 a une forme générale de fer à cheval permettant de loger un porte-balai de la machine électrique, détaillé par la suite, dans le creux du connecteur électrique 500.

Le connecteur électrique 500 a de préférence une forme sensiblement plane et comprend au moins une trace de puissance destinée à être connectée électriquement à au moins des éléments électriques de la machine électrique et/ou d'une source d'énergie électrique. En particulier, le connecteur électrique 500 est configuré pour connecter électriquement l'unité électronique de puissance et/ou l'unité électronique de contrôle à la au moins une trace de puissance.

Par exemple, le connecteur électrique 500 illustré sur la figure 4 comprend trois traces de puissance comprises au moins en partie dans le plan du connecteur électrique 500. Par exemple, la première trace de puissance est destinée à connecter électriquement un module électronique de puissance à une phase de la machine électrique, la deuxième trace de puissance est destinée à être connectée électriquement à un pôle de polarité positif d'une source d'énergie électrique de manière à alimenter un module électronique de puissance et/ou la carte électronique de contrôle, et la troisième trace de puissance est destinée à être connectée électriquement à un pôle de polarité négatif ou à la masse d'une source d'énergie électrique de manière à alimenter un module électronique de puissance et/ou la carte électronique de contrôle.

Les traces de puissance sont surmoulées au moins en partie de matériau isolant électriquement, par exemple de matériau plastique. Une partie du surmoulage 508 des traces de puissance est visible sur la figure 4.

De préférence, les deuxième et troisième traces de puissance sont au moins en partie superposées selon une direction sensiblement perpendiculaire au plan du connecteur électrique 500. Autrement dit, les deuxième et troisième traces de puissance sont au moins en partie disposées l'une au-dessus de l'autre dans la forme sensiblement plane du connecteur électrique 500.

Les deuxième et troisième traces de puissance sont séparées par un matériau isolant, en général un matériau isolant électriquement comme par exemple un matériau plastique. De préférence, l'épaisseur du matériau isolant séparant la superposition de deux portions des deuxième et troisième traces de puissance est inférieure ou égale à 2 mm, notamment égale à 1 mm. De façon très avantageuse, l'épaisseur du matériau isolant est supérieure ou égale à 1 micron et inférieure ou égale à 100 microns.

En outre, chaque trace de puissance comprend au moins une borne dépourvue de surmoulage, de sorte qu'un contact électrique puisse être réalisé avec un module électronique de puissance. Une borne est de préférence située dans le plan du connecteur électrique 10, et est rendue accessible par une fenêtre dans le matériau isolant électriquement. La première trace de puissance comprend deux bornes 502 visibles sur la figure 4, la deuxième trace de puissance comprend trois bornes 504 et la troisième trace de puissance comprend six bornes 506. Les bornes 502, 504 et 506 permettent une connexion électrique avec les modules électroniques de puissance. De façon avantageuse, les deuxième et troisième traces de puissance sont totalement superposées sauf au niveau des bornes, de sorte à permettre une connexion électrique entre le connecteur électrique et un module électronique de puissance, tout en maximisant la surface de superposition des traces de puissance. Cette configuration permet en outre un gain de place au sein du connecteur électrique.

Les deuxième et troisième traces de puissance peuvent également comprendre chacune au moins un ergot, également appelé broche, destiné à être connecté électriquement à la carte électronique. Les ergots 514, 516 s'étendent de préférence depuis le plan du connecteur électrique 500 en direction de la carte électronique. Avantageusement, l'ergot de chacune des deuxième et troisième traces de puissance est respectivement situé à une extrémité desdites traces de puissance. En outre, l'ergot 514 de la deuxième trace de puissance peut être adjacent à l'ergot 516 de la troisième trace de puissance, comme illustré sur la figure 4, afin de faciliter la connexion avec la carte électronique de contrôle. Par exemple, les ergots 514, 516 sont adjacents et sensiblement situés au milieu du connecteur électrique 500. De préférence, le surmoulage 508 des deuxième et troisième traces de puissance relie mécaniquement l'ergot 514 de la deuxième trace de puissance et l'ergot 516 de la troisième trace de puissance. Notamment, les ergots 514, 516 des deuxième et troisième traces de puissance sont en métal.

Le connecteur électrique 500 peut également comprendre un joint 518 s'étendant entre la carte électronique et le connecteur électrique 500 et autour de chaque ergot 514, 516 permettant de garantir l'étanchéité entre le connecteur électrique 500 et la carte électronique au niveau des ergots 514, 516 lors de l'isolation de la carte électronique avec le matériau isolant. Ce joint 518 permet en outre d'éviter que le matériau isolant B s'écoule autour des ergots 514, 516.

En outre, comme représenté sur la figure 4, le connecteur électrique 500 peut comprendre au moins un orifice traversant 520 destiné à recevoir le au moins un élément de connexion électrique. De préférence, l'orifice traversant 520 a une forme générale de cylindre et comprend au moins une paroi latérale 522 s'étendant depuis la partie sensiblement plane du connecteur électrique 500 dans une direction sensiblement perpendiculaire à au plan du connecteur électrique 500, notamment en direction de la carte électronique. De façon avantageuse, la paroi latérale 522 permet de protéger mécaniquement les éléments de connexion électrique.

Avantageusement, la paroi latérale 522 comprend au moins une partie du pourtour de l'orifice traversant 520, comme illustré sur la figure 4. La paroi latérale 522 a de préférence une hauteur supérieure ou égale à 2 mm et inférieure ou égale à 10 mm, et une épaisseur inférieure ou égale à 3 mm et supérieure ou égale à 0.5 mm.

Le connecteur électrique 500 peut comprendre une pluralité d'orifices traversants 520, chaque orifice traversant 520 étant destiné à recevoir au moins un élément de connexion électrique de la carte électronique de contrôle avec chaque module électronique de puissance. Par exemple, sur la figure 4, le connecteur électrique 500 comprend trois orifices traversants 520, chaque orifice traversant 520 comprenant une paroi latérale 522.

Comme indiqué précédemment, l'architecture électronique 10 selon l'invention comprend avantageusement un connecteur de bloc de capacités 600.

Le connecteur de bloc de capacités est notamment supporté par une deuxième partie 204 du dissipateur thermique 200 visible sur la figure 2, distincte de la première partie 202 supportant les modules électronique de puissance 100. Les première et deuxième parties 202, 204 du dissipateur thermique 200 sont notamment séparées l'une de l'autre par au moins un muret 208. Le muret 208 permet notamment l'isolation des modules électroniques de puissance 100 dans la première partie du dissipateur thermique 200.

Le connecteur électrique 500 et le connecteur de bloc de capacités 600 sont connectés électriquement de sorte à fournir de la puissance aux modules électroniques de puissance 100. Le connecteur de bloc de capacités 600 peut avoir une forme générale de fer à cheval. En particulier, le connecteur de bloc de capacités 600 et du connecteur électrique 500 forment le pourtour d'un orifice destiné à recevoir le porte-balai de la machine électrique.

Le connecteur de bloc de capacités 600 comprend au moins une quatrième trace de puissance et une cinquième trace de puissance. Par exemple, la quatrième trace de puissance est destinée à être connectée électriquement à un pôle de polarité positif d'une source d'énergie électrique, et la cinquième trace de puissance est destinée à être connectée électriquement à un pôle de polarité négatif ou à la masse d'une source d'énergie électrique. Les quatrième et cinquième traces de puissance sont distinctes l'une de l'autre et surmoulées au moins en partie de matériau isolant électriquement, par exemple de matériau plastique. Par exemple, une partie du surmoulage 608 des traces de puissance est notamment visible sur la figure 4.

De façon analogue aux deuxième et troisième traces de puissance du connecteur électrique 500, les quatrième et cinquième traces de puissance du connecteur de bloc de capacités sont, de préférence, au moins en partie superposées et séparées par un matériau isolant électriquement comme par exemple un matériau plastique. Plus précisément, les traces de puissances sont au moins en partie disposées l'une au-dessus de l'autre au sein du connecteur de bloc de capacités 600. Par exemple, sur la figure 4, au moins une portion des quatrième et cinquième traces de puissance sont superposées selon une direction sensiblement perpendiculaire au plan du connecteur électrique 500.

En outre, chaque trace de puissance comprend au moins une borne dépourvue de surmoulage destinée à être connectée électriquement aux modules électroniques de puissance 100 et au connecteur électrique 500 de sorte à fournir de la puissance aux modules électroniques. Comme illustré en figure 4, la quatrième trace de puissance comprend au moins une borne 604, et la cinquième trace de puissance comprend au moins une borne 606.

Avantageusement, une borne 604 de la quatrième trace de puissance du connecteur de blocs de capacités 600 et une borne 504 de la deuxième trace de puissance du connecteur électrique 500 sont destinées à être connectées électriquement, et une borne 606 de la cinquième trace de puissance du connecteur de blocs de capacités 600 et une borne 506 de la troisième trace de puissance du connecteur électrique 500 sont destinées à être connectées électriquement.

En outre, le connecteur de bloc de capacités 600 peut comprendre au moins un bloc de capacités 614 comprenant au moins une capacité de liaison 610. Par exemple, comme illustré sur la figure 4, le connecteur de bloc de capacités 600 comprend deux blocs de capacités 614 situés sensiblement symétriquement sur la forme de fer à cheval du connecteur de blocs de capacités 600, chaque bloc de capacités 614 comprenant trois capacités de liaison 610. Le connecteur de bloc de capacités 600 connecte électriquement le au moins un bloc de capacités 614 au connecteur électrique 500.

De façon additionnelle, le connecteur de blocs de capacités 600 peut comprendre un noyau ferromagnétique, par exemple un tore magnétique 612 tel que représenté sur la figure 4, destiné à mesurer le courant électrique traversant les capacités de liaison.

En outre, selon le mode de réalisation, l'architecture électronique 10 comprend avantageusement au moins un capteur agencé dans un porte-capteur 700. Le porte-capteur 700 est réalisé en matière isolante électriquement, par exemple en matière plastique.

De préférence, le porte-capteur 700 comprend une pluralité de capteurs, par exemple trois capteurs à effet hall, configurés pour mesurer la vitesse de rotation et la position du rotor de la machine électrique. Les capteurs à effet hall sont destinés à détecter un champ magnétique émis par un élément magnétique placé sur le rotor de la machine électrique, et à être connectés électriquement à la carte électronique de contrôle 300.

En particulier, le dissipateur thermique 200 peut comprendre un orifice traversant 212 recevant le porte-capteur 700. De préférence, les première et deuxième parties du dissipateur thermique 200 forment le pourtour de l'orifice traversant 212. Le porte-capteur 700 est de préférence vissé au dissipateur thermique 200.

En outre, l'architecture électronique 10 comprend préférentiellement au moins deux balais réalisés en matériau conducteur électriquement agencés dans un porte-balais 800. Le porte-balais 800 est réalisé en matière isolante électriquement, par exemple en matière plastique.

Les balais sont destinés à être connectés électriquement à un pôle de polarité positif et à un pôle de polarité négatif d'une source d'énergie électrique, de sorte à permettre l'alimentation électrique du rotor de la machine électrique. Par exemple, le porte-balais 800 comprend un corps 802, notamment visible sur la figure 6, dans lequel le rotor 4 de la machine électrique 1 est destiné à être inséré.

Les balais permettent un contact électrique permanent entre l'architecture électronique et un arbre 4 du rotor de la machine électrique. Le contact électrique est réalisé par frottement entre les balais et l'arbre 4 du rotor de la machine électrique qui est mobile en rotation autour d'un axe de la machine électrique.

Le porte-balai 800 comprend avantageusement un ressort à une extrémité de chaque balai permettant d'exercer une tension en direction de l'arbre 4 du rotor. Plus précisément, le ressort permet de compenser l'usure d'un balai de sorte à permettre un contact électrique permanent entre les balais et l'arbre 4 du rotor.

Avantageusement, l'orifice traversant 212 du dissipateur thermique reçoit également le porte balais 800. Cette configuration permet notamment un gain de place au sein de l'architecture électronique.

Le porte-balai est de préférence vissé au dissipateur thermique 200, ce qui permet un accès rapide et facile aux balais, notamment en cas d'usure de ces derniers.

De façon avantageuse, l'architecture électronique 10 selon l'invention comprend un couvercle de protection 900 permettant une isolation de la carte électronique 300. Le couvercle de protection 900 est réalisé en matériau isolant électriquement, de préférence en plastique, et comprend au moins une piste conductrice électriquement 902, notamment une piste de cuivre, configurée pour être connectée électriquement à la carte électronique de contrôle 300. La piste 902 permet en outre une connexion électrique entre l'architecture électronique et le véhicule automobile dans lequel la machine électrique est destinée à être intégrée. Ce couvercle de protection 902 permet ainsi une réduction des coûts de production, améliore l'adaptabilité de l'architecture électronique au véhicule automobile et facilite l'installation de l'architecture électronique dans le véhicule automobile.

L'architecture électronique destinée à alimenter une machine électrique pour véhicule automobile selon l'invention a été décrite dans le cadre d'une pluralité de modules électroniques de puissance et d'une carte électronique de contrôle desdits modules électroniques. Bien entendu, l'invention n'est nullement limitée au mode de réalisation décrit et illustré, qui n'a été donné qu'à titre d'exemple. Au contraire, d'autres applications de l'architecture électronique conforme à l'invention sont également possibles sans sortir du cadre de l'invention.

## Revendications

1. Architecture électronique (10) destinée à alimenter une machine électrique pour véhicule automobile, l'architecture électronique (10) comprenant au moins :
- une unité électronique de puissance (100) ;
- un dissipateur thermique (200) supportant l'unité électronique de puissance (100) ;
- une unité électronique de contrôle (300) configurée pour contrôler ladite unité électronique de puissance (100) ;
- un support (400) de l'unité électronique de contrôle supportant l'unité électronique de contrôle (300) et agencé entre l'unité électronique de puissance (100) et l'unité électronique de contrôle (300) ; et
- un connecteur électrique (500) comprenant au moins une trace de puissance destinée à être connectée électriquement à au moins des éléments électriques de la machine électrique et/ou d'une source d'énergie électrique, le connecteur électrique (500) étant agencé entre l'unité électronique de puissance (100) et le support (400) de l'unité électronique de contrôle et configuré pour connecter électriquement l'unité électronique de puissance (100) et/ou l'unité électronique de contrôle (300) à la au moins une trace de puissance le connecteur électrique (500) comprenant :
- une première trace de puissance destinée à connecter électriquement l'unité électronique de puissance à une phase de la machine électrique ;
- une deuxième trace de puissance destinée à être connectée électriquement à un pôle de polarité positif d'une source d'énergie électrique de manière à alimenter l'unité électronique de puissance (100) et/ou l'unité électronique de contrôle (300) ; et
- une troisième trace de puissance destinée à être connectée électriquement à un pôle de polarité négatif ou à la masse d'une source d'énergie électrique de manière à alimenter l'unité électronique de puissance (100) et/ou l'unité électronique de contrôle (300),
l'unité électronique de puissance (100), le dissipateur thermique (200), le connecteur électrique (500), l'unité électronique de contrôle (300) et le support (400) de l'unité électronique de contrôle s'étendant chacun suivant des plans sensiblement parallèles,
**caractérisée en ce que** l'unité électronique de puissance (100), le dissipateur thermique (200), le connecteur électrique (500), l'unité électronique de contrôle (300) et le support (400) de l'unité électronique de contrôle sont superposés les uns sur les autres.

2. Architecture électronique selon la revendication 1, comprenant en outre au moins un élément de connexion électrique (150) connectant électriquement l'unité électronique de puissance (100) et l'unité électronique de contrôle (300) ; et dans laquelle au moins un espace s'étend entre l'unité électronique de puissance (100) et le support de l'unité électronique de contrôle (400) et autour du au moins un élément de connexion électrique (150), ledit connecteur électrique (500) s'étendant au moins en partie dans ledit espace autour de l'élément de connexion électrique (150).

3. Architecture électronique selon la revendication 2, dans laquelle l'unité électronique de puissance (100), l'unité électronique de contrôle (300) et le au moins un élément de connexion électrique (150) sont noyés dans un matériau isolant (A, B), de sorte que le au moins un espace s'étendant autour du au moins un élément de connexion électrique (150) entre l'unité électronique de puissance (100) et le support de l'unité électronique de contrôle (300) est dépourvu de matériau isolant (A, B).

4. Architecture électronique selon l'une quelconque des revendications 1 à 3, comprenant également un connecteur de bloc de capacités (600) supporté par une deuxième partie (204) du dissipateur thermique (200) distincte d'une première partie (202) supportant l'unité électronique de puissance (100).

5. Architecture électronique selon la revendication 4, dans laquelle la première partie (202) du dissipateur thermique (200) est destinée à être remplie d'un matériau isolant (A), de sorte que l'unité électronique de puissance (100) est noyée dans le matériau isolant (A).

6. Architecture électronique selon l'une quelconque des revendications 1 à 5, comprenant également un couvercle de protection (900) agencé en vis-à-vis de l'unité électronique de contrôle (300).

7. Architecture électronique selon l'une quelconque des revendications 1 à 6, dans laquelle :
- l'unité électronique de puissance comprend au moins un module électronique de puissance (100) ; et
- l'unité électronique de contrôle est une carte électronique de contrôle (300).

8. Machine électrique destinée à être intégrée dans un véhicule automobile, comprenant une architecture électronique (10) selon au moins l'une quelconque des revendications 1 à 7.

## Patentansprüche

1. Elektronischer Aufbau (10) zur Stromversorgung einer elektrischen Maschine für ein Kraftfahrzeug, wobei der elektronische Aufbau (10) mindestens Folgendes aufweist:
- eine elektronische Leistungseinheit (100);
- einen Kühlkörper (200), der die elektronische Leistungseinheit (100) trägt;
- eine elektronische Steuereinheit (300), die ausgebildet ist, um die elektronische Leistungseinheit (100) zu steuern;
- eine Grundplatte (400) der elektronischen Steuereinheit, die die elektronische Steuereinheit (300) trägt und zwischen der elektronischen Leistungseinheit (100) und der elektronischen Steuereinheit (300) angeordnet ist; und
- einen elektrischen Stecker (500), der mindestens einen Leistungsleiter aufweist, der dazu bestimmt ist, mit mindestens elektrischen Elementen der elektrischen Maschine und/oder einer elektrischen Energiequelle elektrisch verbunden zu werden, wobei der elektrische Stecker (500) zwischen der elektronischen Leistungseinheit (100) und der Grundplatte (400) der elektronischen Steuereinheit angeordnet ist und ausgebildet ist, um die elektronische Leistungseinheit (100) und/oder die elektronische Steuereinheit (300) mit dem mindestens einen Leistungsleiter elektrisch zu verbinden, wobei der elektrische Stecker (500) Folgendes aufweist:
- einen ersten Leistungsleiter, um die elektronische Leistungseinheit mit einer Phase der elektrischen Maschine zu verbinden;
- einen zweiten Leistungsleiter, der dazu bestimmt ist, elektrisch mit einem Pol positiver Polarität einer elektrischen Energiequelle verbunden zu werden, um die elektronische Leistungseinheit (100) und/oder die elektronische Steuereinheit (300) mit Strom zu versorgen; und
- einen dritten Leistungsleiter, der dazu bestimmt ist, elektrisch mit einem Pol negativer Polarität oder mit der Masse einer elektrischen Energiequelle verbunden zu werden, um die elektronische Leistungseinheit (100) und/oder die elektronische Steuereinheit (300) mit Strom zu versorgen,
wobei die elektronische Leistungseinheit (100), der Kühlkörper (200), der elektrische Stecker (500), die elektronische Steuereinheit (300) und die Grundplatte (400) der elektronischen Steuereinheit sich jeweils in im Wesentlichen parallelen Ebenen erstrecken,
**dadurch gekennzeichnet, dass** die elektronische Leistungseinheit (100), der Kühlkörper (200), der elektrische Stecker (500), die elektronische Steuereinheit (300) und die Grundplatte (400) der elektronischen Steuereinheit übereinander liegen.

2. Elektronischer Aufbau nach Anspruch 1, der darüber hinaus mindestens einen elektrischen Anschluss (150) aufweist, der die elektronische Leistungseinheit (100) und die elektronische Steuereinheit (300) elektrisch miteinander verbindet; und in dem sich mindestens eine Lücke zwischen der elektronischen Leistungseinheit (100) und der Grundplatte (400) der elektronischen Steuereinheit und um den mindestens einen elektrischen Anschluss (150) herum erstreckt, wobei der elektrische Stecker (500) sich mindestens teilweise in die Lücke um den elektrischen Anschluss (150) herum erstreckt.

3. Elektronischer Aufbau nach Anspruch 2, in dem die elektronische Leistungseinheit (100), die elektronische Steuereinheit (300) und der mindestens eine elektrische Anschluss (150) in ein Isoliermaterial (A, B) eingebettet sind, sodass die mindestens eine Lücke, die sich um den mindestens einen elektrischen Anschluss (150) herum zwischen der elektronischen Leistungseinheit (100) und der Grundplatte der elektronischen Steuereinheit (300) erstreckt, frei von Isoliermaterial (A, B) ist.

4. Elektronischer Aufbau nach einem der Ansprüche 1 bis 3, der auch einen Kapazitätsblockstecker (600) aufweist, der von einem zweiten Bestandteil (204) des Kühlkörpers (200) getragen wird, der sich von einem ersten Bestandteil (202), der die elektronische Leistungseinheit (100) trägt, unterscheidet.

5. Elektronischer Aufbau nach Anspruch 4, in dem der erste Bestandteil (202) des Kühlkörpers (200) dazu bestimmt ist, mit einem Isoliermaterial (A) aufgefüllt zu werden, sodass die elektronische Leistungseinheit (100) in das Isoliermaterial (A) eingebettet ist.

6. Elektronischer Aufbau nach einem der Ansprüche 1 bis 5, der auch eine Schutzabdeckung (900) aufweist, die gegenüber der elektronischen Steuereinheit (300) angeordnet ist.

7. Elektronischer Aufbau nach einem der Ansprüche 1 bis 6, in dem:
- die elektronische Leistungseinheit mindestens ein elektronisches Leistungsmodul (100) aufweist; und
- die elektronische Steuereinheit eine elektronische Steuerkarte (300) ist.

8. Elektrische Maschine zur Integration in ein Kraftfahrzeug, die einen elektronischen Aufbau (10) nach mindestens einem der Ansprüche 1 bis 7 aufweist.

## Claims

1. Electronic architecture (10) intended to supply an electric machine for automotive vehicle, the electronic architecture (10) comprising at least:
- an electronic power unit (100);
- a thermal dissipator (200) supporting the electronic power unit (100);
- an electronic control unit (300) configured to control the said electronic power unit (100);
- a support (400) of the electronic control unit supporting the electronic control unit (300) and arranged between the electronic power unit (100) and the electronic control unit (300); and
- an electrical connector (500) comprising at least one power trace intended to be connected electrically to at least some electrical elements of the electric machine and/or of an electrical energy source, the electrical connector (500) being arranged between the electronic power unit (100) and the support (400) of the electronic control unit and configured to electrically connect the electronic power unit (100) and/or the electronic control unit (300) to the at least one power trace,
the electrical connector (500) comprising:
- a first power trace intended to electrically connect the electronic power unit to a phase of the electric machine;
- a second power trace intended to be connected electrically to a positive polarity pole of an electrical energy source so as to supply the electronic power unit (100) and/or the electronic control unit (300); and
- a third power trace intended to be connected electrically to a negative polarity pole or to the earth of an electrical energy source so as to supply the electronic power unit (100) and/or the electronic control unit (300),
the electronic power unit (100), the thermal dissipator (200), the electrical connector (500), the electronic control unit (300) and the support (400) of the electronic control unit each extending along substantially parallel planes,
**characterized in that** the electronic power unit (100), the thermal dissipator (200), the electrical connector (500), the electronic control unit (300) and the support (400) of electronic control unit are superposed one above the other.

2. Electronic architecture according to Claim 1, furthermore comprising at least one electrical connection element (150) electrically connecting the electronic power unit (100) and the electronic control unit (300); and in which at least one space extends between the electronic power unit (100) and the support of the electronic control unit (400) and around the at least one electrical connection element (150), the said electrical connector (500) extending at least in part in the said space around the electrical connection element (150).

3. Electronic architecture according to Claim 2, in which the electronic power unit (100), the electronic control unit (300) and the at least one electrical connection element (150) are embedded in an insulating material (A, B), so that the at least one space extending around the at least one electrical connection element (150) between the electronic power unit (100) and the support of the electronic control unit (300) is devoid of insulating material (A, B).

4. Electronic architecture according to any one of Claims 1 to 3, also comprising a capacitor bank connector (600) supported by a second part (204) of the thermal dissipator (200) distinct from a first part (202) supporting the electronic power unit (100).

5. Electronic architecture according to Claim 4, in which the first part (202) of the thermal dissipator (200) is intended to be filled with an insulating material (A), so that the electronic power unit (100) is embedded in the insulating material (A).

6. Electronic architecture according to any one of Claims 1 to 5, also comprising a protective cover (900) arranged opposite the electronic control unit (300).

7. Electronic architecture according to any one of Claims 1 to 6, in which:
- the electronic power unit comprises at least one electronic power module (100); and
- the electronic control unit is an electronic control board (300).

8. Electric machine intended to be integrated into an automotive vehicle, comprising an electronic architecture (10) according to at least any one of Claims 1 to 7.
